# EUROPEAN PATENT APPLICATION

(11) **EP 0 962 972 A1**
(43) Date of publication of application: **08.12.1999**
(21) Application number: 99304168.0
(22) Date of filing: 28.05.1999
(51) Int. Cl.: H01L 21/8242

(54) **DRAM trench capacitor and method of fabricating the same**

(30) Priority: 02.06.1998 US 88890
(71) Applicant: INTERNATIONAL BUSINESS MACHINES CORPORATION, Armonk, NY 10504 (US); SIEMENS AKTIENGESELLSCHAFT, 80333 München (DE)
(72) Inventor: Economikos, Laertis, Hampshire SO21 2JN (GB); Gruening, Ulrike, Hampshire SO21 2JN (GB); Ho, Herbert L., Hampshire SO21 2JN (GB); Radens, Carl J., Hampshire SO21 2JN (GB); Jammy, Ragarao, Hampshire SO21 2JN (GB); Hoepfner, Joachim, Hampshire SO21 2JN (GB); Shen, Hua, Hampshire SO21 2JN (GB)
(74) Representative: Zerbi, Guido Maria

(57) **Abstract**

A storage node for deep trench-based storage capacitor is formed by etching a trench (11) in a surface of a semiconductor substrate (10), forming a layer of dielectric (14) on a sidewall of the trench, partially removing the layer of dielectric material in order to expose an upper portion of the sidewall, growing a layer of oxide (16) on the upper portion of the sidewall, removing the remainder of the layer of dielectric material, doping to form a buried plate (17), forming a node dielectric (18), and forming an inner electrode (19) within the trench. The oxide layer at the upper portion of the trench is preferably formed by a LOCOS technique.

## Description

### Technical Field

The present invention is concerned with a method for fabricating a storage node for deep trench-based storage capacitor and is especially concerned with a method for fabricating the isolation collar and buried plate structure requiring only one trench recess process. In particular, the present invention provides a process that achieves self alignment between the collar and buried plate. Moreover, a LOCOS process is employed for fabricating the collar of the structure. The present invention is also concerned with a new deep-trench-based storage capacitor structure.

### Background of Invention

High processing speed in currently available data processors must be supported by large amounts of high speed random access memory. Due to reduced device counts per memory cell, much of the required storage is provided by dynamic random access memories (DRAMs) so that a significantly greater number of memory cells can be provided on a single integrated circuit chip. In such devices, the density at which memory cells (principally comprising one storage capacitor per memory cell) are configured is of great importance since the capacitance of each capacitor is very limited due to small size, while that storage capacitance must be large compared to the capacitance of the bit line to achieve adequate operating margins for the sense amplifiers used to detect the presence or absence of stored charge. Therefore, the trenches are formed to relatively large depths while being very closely spaced. These same geometries are also important for other trench structures such as isolation trenches.

In recent years, it has also been the practice to provide a buried plate within the semiconductor substrate in which the trench capacitors are formed. The buried plate is a region surrounding the sides and bottom of a storage node trench in the dynamic random access memory cell which acts as the fixed potential terminal for the storage capacitor. The buried plate typically extends down the sides of the storage node trench about 6 microns. The depth at which the top surface of the buried plate is located should be a set distance such as 1.5 ± 0.4 microns below the surface of the semiconductor substrate.

The buried plate can be fabricated using resist recess processing along with out-diffusing of a dopant such as arsenic from the lower portion of a trench. U.S. Patent 5,618,751 to Golden et al and assigned to International Business Machines Corporation describes one such process.

A well known type of DRAM employs a deep trench capacitor as shown in "A 0.6 m² 256 mb Trench DRAM Cell with Self-Aligned Buried Strap (BEST)" by Nesbit et al in *Technical Digest of the International Electron Devices* Meeting, Washington, D.C., p. 627, 1993. Deep trench capacitors were typically made by a process employing three etch steps on the capacitor polysilicon fill and two collar formation steps to isolate the buried capacitor plate and to provide a strap connection to bridge the collar at the top of the capacitor and connect to the pass transistor. Such a process suffers from a very narrow tolerance and high stress and high contact resistance. More recently, an improved process reducing the number of etch steps has been developed. In particular, see U.S. Patent 5,395,786 to Hsu et al and assigned to International Business Machines Corporation, disclosure of which is incorporated herein by reference.

Nevertheless, prior art processes have required two independent trench recess steps for creating the buried plate and the isolation collar. Because such steps are difficult to control, problems are still encountered. Moreover, reliability concerns exist with the node-collar interface.

### Summary of Invention

It is an object of the present invention to provide a technique which alleviates the above drawbacks.

According to the present invention we provide a method of fabricating storage node for deep trench-based storage capacitor on a semiconductor substrate which comprises: etching a trench in a surface of said semiconductor substrate; forming a layer of dielectric on a sidewall of said trench; partially removing said layer of dielectric in order to expose an underlying region of an upper portion of said sidewall; growing a layer of oxide on said upper portion of said sidewall; removing the remaining portion of said dielectric from sidewall of said trench; doping to form a buried plate; forming a trench dielectric on at least the lower trench sidewalls to provide a node dielectric; and forming an inner electrode within said trench.

Further according to the present invention we provide a semiconductor structure which comprises a semiconductor substrate comprising a trench recessed in said substrate; a collar oxide located adjacent an upper portion of said trench; buried plate self-aligned to said collar oxide; dielectric layer within said trench and extending to the top of said trench; and an inner electrode within said trench.

Moreover, according to a preferred embodiment of the present invention, the buried plate and collar are self- aligned. In particular, the method according to a preferred embodiment of the present invention is concerned with etching a trench in a surface of a semiconductor substrate and forming a layer of dielectric material on a sidewall of the trench. The layer of dielectric material is partially removed from the upper region of the trench in order to expose an underlying region of an upper portion of the sidewall of the trench. A layer of oxide is then grown in this upper portion of the sidewall. The dielectric is removed from the remainder of the sidewall and the buried plate is formed by doping. A layer of dielectric is provided on the walls of the trench including over the collar and node (i.e. trench wall at the buried plate). An inner electrode is formed within the trench. The present invention is also concerned with the structure obtained by the above-disclosed process.

An embodiment of the present invention is also concerned with a semiconductor structure which comprises a semiconductor substrate comprising a trench in the substrate, a collar oxide located adjacent an upper portion of the trench, buried plate self- aligned to the collar oxide, dielectric layer within the trench and extending to the top of the trench, and an inner electrode within the trench. The dielectric layer extending to the top of the trench is advantageous especially due to its presence at the transition at the bottom of the collar.

Still other objects and advantages of the present invention will become readily apparent by those skilled in the art from the following detailed description, wherein it is shown and described only the preferred embodiments of the invention, simply by way of illustration of the best mode contemplated of carrying out the invention. As will be realized the invention is capable of other and different embodiments, and its several details are capable of modifications in various obvious respects, without departing from the invention. Accordingly, the description is to be regarded as illustrative in nature and not as restrictive.

### Brief Description of the Drawings

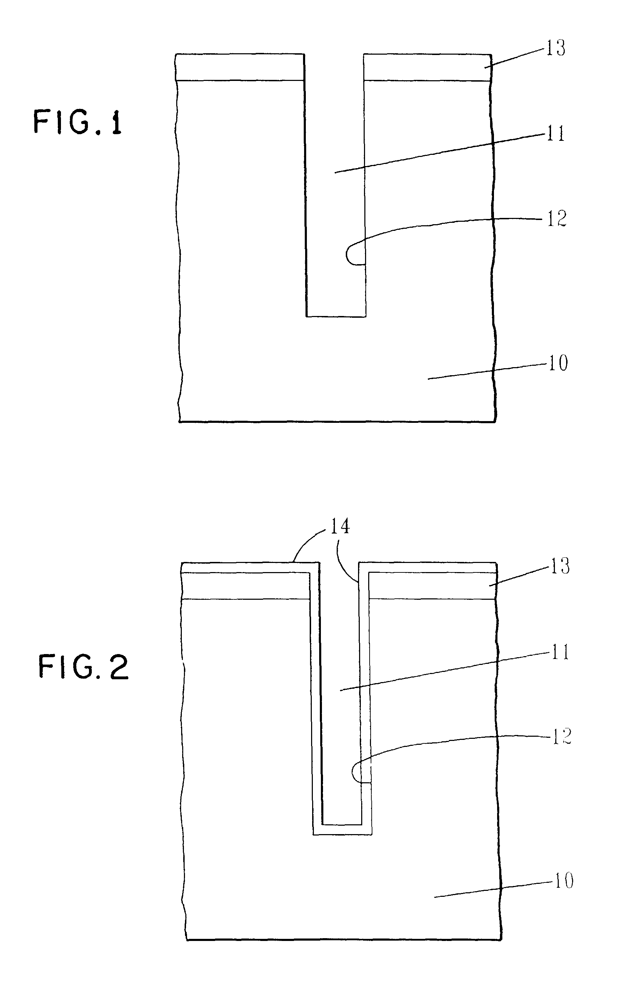

Figs. 1-10 are cross-sectional views through a deep trench storage capacitor during various stages of the fabricating process of the present invention.

### Best and Various Modes for Carrying Out Invention

In order to facilitate an understanding of the present invention, reference will be made to the figures which illustrate a diagrammatic representation of the steps of fabricating the structure according to the present invention.

It is to be understood that when the discussion refers to n-type impurities, the particular process steps are applicable to p-type impurities, and vice versa. Also, the present invention is applicable to substrates other than silicon which are known in the art such as other semiconductor materials including group III-V semiconductors.
Furthermore, when reference is made to impurities of a "first type" and to impurities of a "second type" it is understood that the "first type" refers to n- or p-type impurities and "second type" refers to the opposite conductivity type. That is, if the "first type" is p, then the "second type" is n. If the "first type" is n, then the "second type" is p. P-dopants for silicon include boron, aluminum, gallium and indium. N-type dopants for silicon include arsenic, phosphorus and antimony.

Referring to Fig. 1, a cross-sectional view through one of deep trenches 11 etched in a silicon substrate 10 is shown. The trench can be etched by conventional directional etch process such as reactive ion etching (RIE) using, for example HBr, NF₃, O₂, SiCl₄ to a depth typically of about 5 to about 8 microns exposing trench sidewalls 12. The shape of the trench is not limited to those having parallel walls but include other shapes such as those with tapered walls or reentrant profiles (e.g. bottle-shaped). A typical silicon semiconductor substrate is a P-type silicon substrate having crystal orientation <100>. In addition, a pad dielectric layer 13 is deposited on substrate 10 before etching the trench. A typical example of a layer 13 is silicon nitride deposited by a conventional chemical vapour deposition procedure such as a low pressure chemical vapour deposition technique (LPCVD). This layer 13 is typically about 1000 to about 5000 Å. A layer of dielectric 14 is formed on the walls of the trench such as by chemical vapour deposition to provide a silicon nitride and/or silicon oxidel dielectric barrier with silicon nitride being preferred. In addition, a thin layer of thermal silicon dioxide (not shown in the figures) may be grown to a thickness of about 20 Å - 100 Å as a pad layer prior to the chemical vapour deposition of the SiN layer. In a typical example, a silicon nitride layer of about 20 to about 100 Å, an example of which being 50 Å, is deposited by a low pressure chemical vapour deposition process (see Fig. 2).

Photoresist 15 is then deposited in trench 11 and then subjected to an etch recess process such as the chemical down-stream etching (CDE) technique to remove the photoresist down to a first level, which is equal to or greater than the depth of the array well in the substrate, which is typically about 0.8 to about 1.2 microns beneath the substrate surface. The upper portion of dielectric layer 14 not protected by photoresist 15 is then removed by etching. For instance, in the case of silicon nitride, the etching can be carried out using an isotropic etch process such as chemical down-stream etching (CDE). A typical photoresist that can be employed is Shipley AZ-7500.

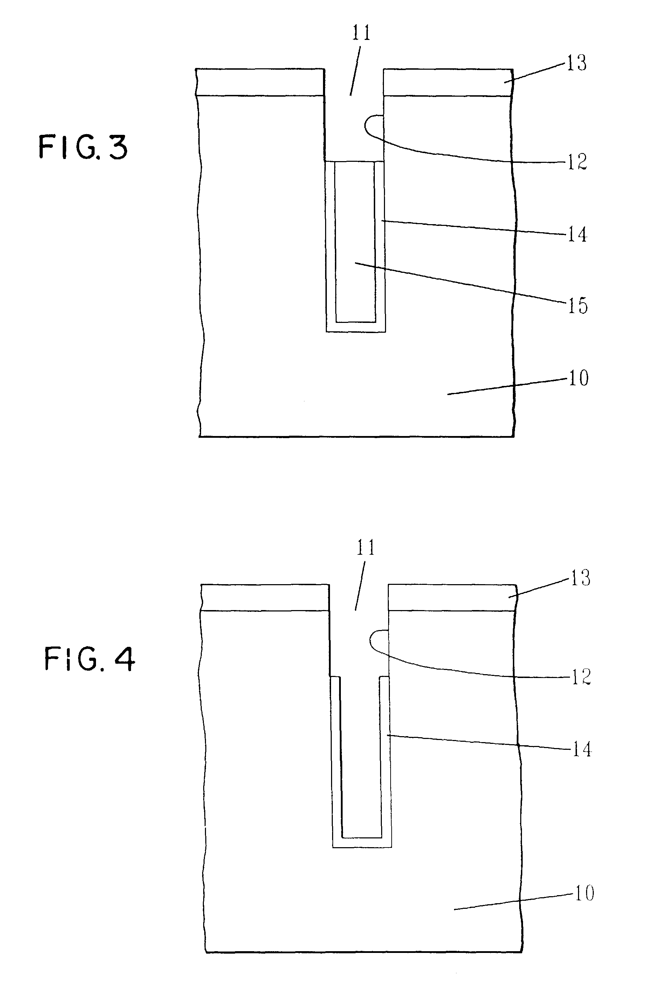

The remaining photoresist 15 is then removed from the trench employing conventional wet photoresist strip processes. The dielectric layer 14 remains in the lower region of trench 11. See Fig. 4.

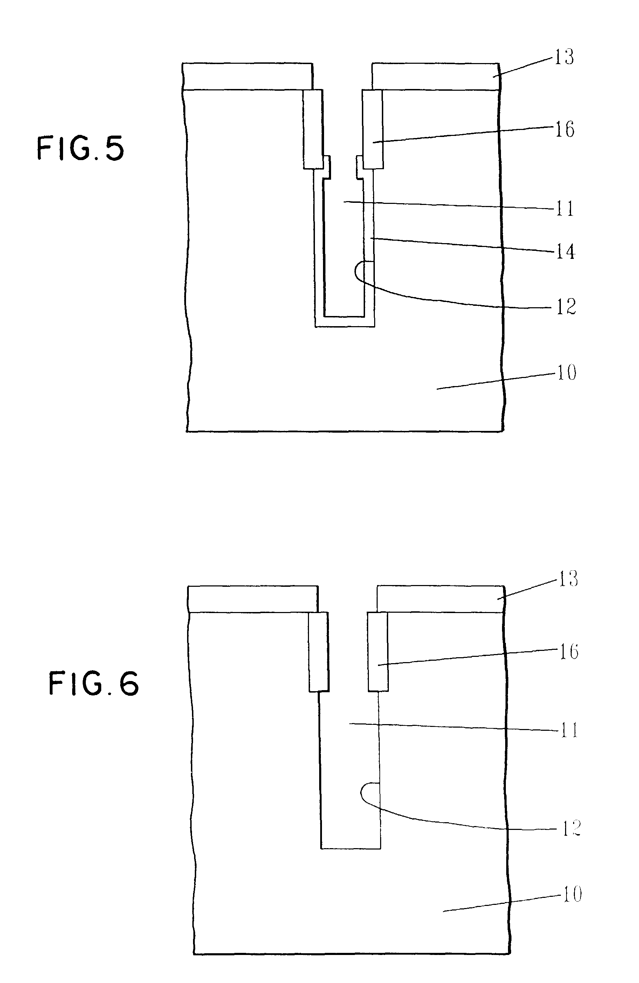

The exposed silicon in the upper region of the trench is then oxidized by heating to temperatures of about 800⁻C to about 1100⁻C in the presence of wet or preferably dry oxygen the provide collar oxide 16. The oxidation is carried out for about 2 to about 10 mins. to provide a collar oxide 16 of about 10 to about 50 nanometers. In a typical example, the oxidation is carried out at a temperature of about 1050⁻C in the presence of dry oxygen for about 5 minutes to provide silicon oxide having a thickness of about 350Å. The dielectric silicon nitride layer 14 on the sidewalls and pad nitride 13 mask the other parts of the structure from oxidation in these other areas. See Fig. 5.

The silicon nitride layer 14 within trench 11 is then removed by etching such as employing a HF-glycerol etch. In a typical example, this takes about 50 to about 100 seconds. See Fig. 6.

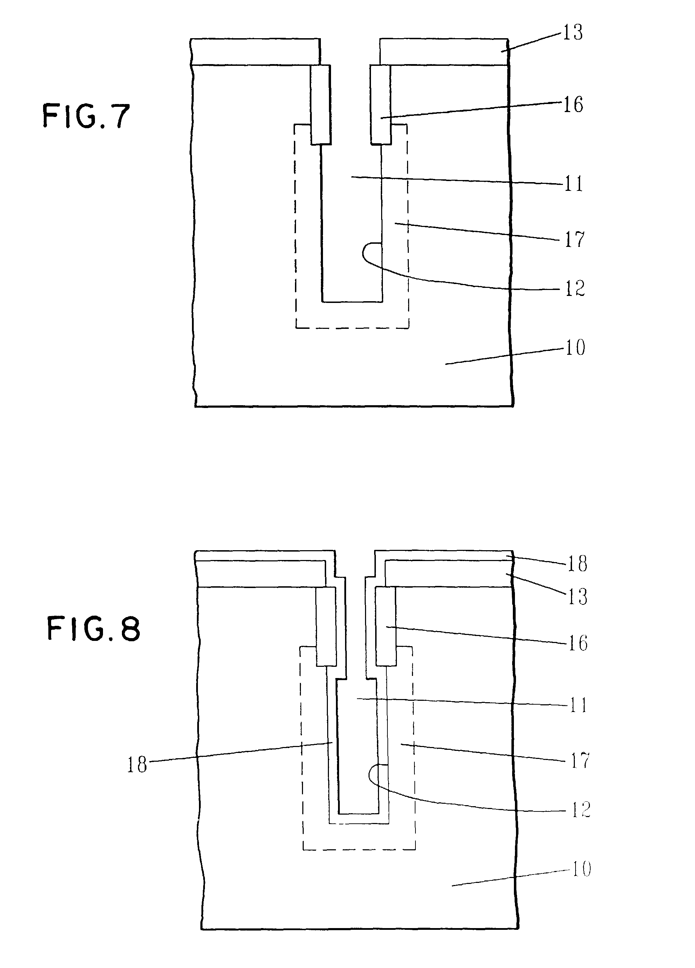

The buried plate 17 can then be formed by doping with an impurity of the opposite type of the substrate. For instance, when the substrate is a p-type, the dopant will be an n-type and preferably in the case of silicon is arsenic. The dopant is incorporated into the lower region of the trench with the collar and pad nitride masking those areas where the dopant is not to be present. The concentration of the dopant is typically about 1 x 10¹⁸ to about 5 x 10²⁰, an example being about 5 x 10¹⁹ atoms/cm³. The dopant can be provided by depositing a doped silicate glass such as arsenic silicate glass followed by an anneal at a temperature of about 900 to about 1100⁻C to cause the arsenic to diffuse out and form the desired plate. The remaining silicate glass, i.e. arsenic- depleted silicate, can then be removed by etching. See Fig. 7. The dopant can be introduced by other techniques such as plasma doping such as a gas-phase anneal in arsene, or plasma ion immersion implantation.

Node dielectric 18 is then formed such as employing a thermal nitridization process at temperatures of about 900⁻C to about 1000⁻C in the presence of NH₃ followed by depositing a layer of about 15 to about 100 Å thick of silicon nitride. The silicon nitride can be deposited by LPCVD technique. Also if desired, the nitride layer can then be oxidized to form a silicon oxynitride layer.

Also, if desired, prior to forming the node dielectric layer, a sacrificial oxide layer of about 50 to about 500 Å can be formed in the trench and then removed in order to eliminate any damaged layer caused by the doping to form the buried plate.

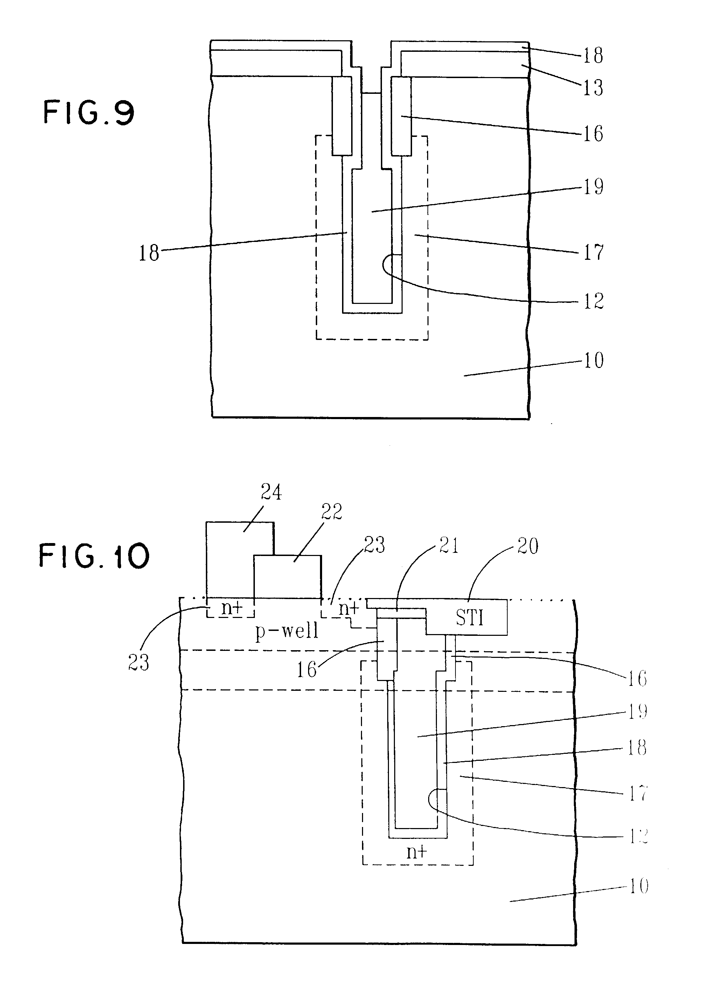

The inner electrode 19 in trench 11 is then provided such as depositing silicon doped with the same conductivity type as the dopant for the buried plate. The inner electrode can also be referred to as the storage node. The structure can then be subjected to planarization such as employing chemical mechanical polishing (CMP) followed by providing a strap electrical contact 21 between the storage node and silicon substrate. This can be achieved by recessing the inner electrode, followed by removing node dielectric, etching collar oxide and then filling in additional electrode material. As illustrated in Fig. 10, shallow trench isolation 20 can be provided followed by conventional fabricating including providing gates 22, source and drain regions 23, and conductive contacts 24 to the gate.

According to the present invention, the process results in the collar and buried plate being self-aligned along with achieving a reliable formation of the node dielectric over the collar. Moreover, the present invention makes it possible to use a variety of techniques to provide the buried plate doping and reduces the variations on the pad SiN due to a reduction in the number of process steps. The process of the present invention eliminates critical etching or recessing steps such as using the same etching for both the photoresist needed and node electrode.

The following non-limiting example is present to further reinstate the invention.

### Example

A pad silicon nitride layer of about 2200 thick is deposited on a p-silicon substrate, and then deep trenches are etched through the pad nitride layer into the silicon. A layer of about 50 thick of silicon nitride dielectric is formed on the walls of the trenches by low pressure chemical vapour deposition. Shipley AZ- 7500 photoresist is then deposited in the trenches and subjected to chemical down-stream etching to recess the photoresist down to about 0.9 microns beneath the surface of the silicon substrate which is greater than the array well in the silicon substrate.

The upper portion of the silicon nitride dielectric in the trenches no longer protected by the photoresist is removed by chemical downstream etching. The remaining photoresist in the trenches is removed by a conventional wet photoresist strip process.

The exposed silicon in the upper region of the trenches is oxidized by heating to about 1050⁻C in the presence of dry oxygen for about 5 minutes to provide a collar oxide of about 350 . The silicon nitride layer within the trenches is removed by etching with a HF-glycerol etch.

The buried plate is then formed by implanting about 5 x 10¹⁹ atoms/cm³ of arsenic using a gas-phase diffusion and drive-in anneal to a temperature of about 1000⁻C. A sacrificial oxide layer of about 100 is formed in the trench and then removed. The node dielectric is then formed by thermal nitridization at a temperature of about 900⁻C in the presence of NH₃ to provide a layer of silicon nitride of about 20 .

The inner electrode is formed by depositing N-type silicon followed by chemical mechanical polishing. A strap electrical contact is provided between the inner electrode and silicon substrate by recessing the inner electrode, node silicon nitride dielectric, and collar oxide and then filling in additional electrode material.

## Claims

1. A method of fabricating storage node for deep trench-based storage capacitor on a semiconductor substrate which comprises:
etching a trench in a surface of said semiconductor substrate;
forming a layer of dielectric on a sidewall of said trench;
partially removing said layer of dielectric in order to expose an underlying region of an upper portion of said sidewall;
growing a layer of oxide on said upper portion of said sidewall; removing the remaining portion of said dielectric from sidewall of said trench;
doping to form a buried plate;
forming a trench dielectric on at least the lower trench sidewalls to provide a node dielectric; and
forming an inner electrode within said trench.

2. The method of claim 1 wherein said layer of dielectric on said sidewalls of said trench comprises silicon nitride.

3. The method of any preceding claim wherein said inner electrode comprises doped silicon.

4. The method of any preceding claim which comprises growing a layer of said oxide on said upper portion of said sidewall by localized oxidation of silicon.

5. The method of any preceding claim wherein said substrate comprises silicon.

6. The method of any preceding claim wherein said buried plate is formed by doping with arsenic followed by heating to cause the arsenic to migrate.

7. The method of any preceding claim wherein said dielectric on the lower portion of said trench includes silicon nitride.

8. The method of any preceding claim wherein the upper portion of said sidewall is about 0.8 to about 1.2 microns.

9. The method of any preceding claim which further comprises:
etching said inner electrode and said collar dielectric to a strap depth thereby exposing a strap contact surface on a portion of said collar sidewalls and an electrode contact surface on the top of said inner electrode;
forming a conductive strap between said strap contact surface and said inner electrode.

10. The method of claim 9 wherein said conductive strap comprises doped polycrystalline silicon.

11. The method of any preceding claim for fabricating a DRAM.

12. The semiconductor structure obtained by the process of any claim 1 to 10.

13. A semiconductor structure which comprises a semiconductor substrate comprising a trench recessed in said substrate; a collar oxide located adjacent an upper portion of said trench; buried plate self-aligned to said collar oxide; dielectric layer within said trench and extending to the top of said trench; and an inner electrode within said trench.

14. The semiconductor structure of claim 13 wherein said dielectric layer within said trench comprises silicon nitride.

15. The semiconductor structure of claim 13 or 14 wherein said inner electrode comprises doped silicon.

16. The semiconductor structure of claim 13, 14 or 15 wherein said substrate comprises silicon.

17. The semiconductor structure of claim 13, 14, 15 or 16 wherein said buried plate comprises arsenic.

18. The structure of claim 13, 14, 15, 16 or 17 wherein the upper portion of said sidewall is about 0.8 to about 1.2 microns beneath the top surface of the semiconductor substrate.

19. The semiconductor structure of claim 13, 14, 15, 16, 17 or 18 wherein said trench is about 5 to about 8 microns deep.

20. The structure of claim 13 being a DRAM.
